# EUROPEAN PATENT APPLICATION

(11) **EP 1 371 747 A1**
(43) Date of publication of application: **17.12.2003**
(21) Application number: 01273953.8
(22) Date of filing: 30.11.2001
(51) Int. Cl.: C23C 14/34, G11B 7/24, G11B 7/26

(54) **ZNS-SIO 2 SPUTTERING TARGET AND OPTICAL RECORDING MEDIUM HAVING ZNS-SIO 2 PHASE-CHANGE TYPE OPTICAL DISC PROTECTIVE FILM FORMED THROUGH USE OF THAT TARGET**

(30) Priority: 12.03.2001 JP 2001068317
(71) Applicant: Nikko Materials Company, Limited, Tokyo 105-8407 (JP)
(72) Inventor: YAHAGI, Masataka, c/o Isohara Factory, Kitaibaraki-shi, Ibaraki 319-1535 (JP); TAKAMI, Hideo, c/o Isohara Factory, Kitaonaraki-shi, Ibaraki 319-1535 (JP)
(74) Representative: Meddle, Alan Leonard
(86) International application number: JP0110509
(87) International publication number: WO02072910

(57) **Abstract**

The present invention relates to a ZnS-SiO₂ sputtering target having a relative density of 90% or more characterized in being sintered with powder wherein 1 to 50mol% of SiO₂ glass powder containing, as an additive, a total of 0.01 to 20wt% of one or more types selected from a metal element, boron, phosphorus, arsenic or the oxides thereof, and the remnant ZnS powder are evenly dispersed and mixed. By enabling the stable manufacture of a target at low cost and in which the SiO₂ crystal grain is minute and of a high density of 90% or more, obtained is a sputtering target for forming an optical disc protective film capable of further improving the evenness of deposition and increasing the productivity rate, and an optical recording medium having formed thereon a ZnS-SiO₂ phase change optical disc protective film upon employing the ZnS-SiO₂ sputtering target.

## Description

### Technical Field

The present invention relates particularly to a ZnS-SiO₂ sputtering target effective in forming a ZnS-SiO₂ phase change optical disc protective film capable of reducing particles (raising dust) and nodules generated at the time of sputtering upon forming a film with sputtering, and improving the productivity of high-density products without much variation in the quality, as well as to an optical recording medium having formed thereon the ZnS-SiO₂ phase change optical disc protective film using such a target.

### Background Art

In recent years, high-density recordable optical disc technology capable of recording/playing without requiring a magnetic head has been developed, and is rapidly attracting attention. This optical disc can be classified into the three categories of read-only, write-once and rewritable. Particularly, the phase change method employed in the write-once and rewritable type discs is attracting attention. The fundamental principle of the recording/ playing employing this phase change optical disc is briefly described below.

This phase change optical disc performs the recording/ playing of information by heating and increasing the temperature of a recording thin film on a substrate by irradiating a laser beam thereto, and generating a crystallographic phase change (amorphous ⇔ crystal) in the structure of such recording thin film. More specifically, the playing of information is conducted by detecting the change in the reflectivity caused by the change in the optical constant of the phase.

The aforementioned phase change is performed with the irradiation of a laser beam narrowed down to a diameter of approximately 1 to several µm. Here, for example, when a 1µm laser beam passes through at a linear velocity of 10m/s, light is irradiated to a certain point on the optical disc for 100ns, and it is necessary to perform the aforementioned phase change and detect the reflectivity within such time frame.

Moreover, in order to realize the foregoing crystallographic phase change; that is, the phase change of the amorphous and crystal, not only will the phase change recording layer be subject to fusion and quenching more than once, the peripheral dielectric protective layer and aluminum alloy reflective layer will also be repeatedly adject thereto.

In light of the above, a phase change optical disc has a four-layer structure wherein, for instance, both sides of a Ge-Sb-Te recording thin film layer are sandwiched with a protective layer of ZnS-SiO₂ high-melting point dielectric, and an aluminum alloy reflective layer is additionally provided thereto.

Among the above, in addition to being demanded of an optical function capable of increasing the absorption of the amorphous portion and crystal portion and which has a large reflectivity difference, the reflective layer and protective layer are also demanded of a function for preventing the deformation caused by the moisture resistance or heat of the recording thin film as well as a function for controlling the thermal conditions upon recording (c.f. *"Kogaku"* magazine, volume 26, no. 1, pages 9 to 15).

As described above, the protective layer of a high-melting point dielectric must be durable against repeated thermal stress caused by the heating and cooling, must not allow such thermal effect to influence the reflective film or other areas, and it is also required to be thin, of low reflectivity, and possess strength to prevent deterioration. From this perspective, the dielectric protective layer plays an important role.

The dielectric protective layer described above is usually formed with the sputtering method. This sputtering method makes a positive electrode target and a negative electrode target face each other, and generates an electric field by applying a high voltage between the substrates thereof and the targets under an inert gas atmosphere. The sputtering method employs a fundamental principle where plasma is formed pursuant to the collision of electrons, which are ionized at such time, and the inert gas, the positive ion in this plasma extrudes the target structured atoms by colliding with the target (negative electrode) surface, and the extruded atoms adhere to the opposing substrate surface.

Conventionally, since the aforementioned protective layer is demanded of permeability, heat resistance, and so on in a visible optical band, sputtering is conducted with a ceramic target such as ZnS-SiO₂ in order to form a thin film of approximately 1000 to 2000Å.

These materials are deposited with a high-frequency sputtering (RF) device, a magnetron-sputtering device, or with a DC (direct current) sputtering device upon conducting special processing to the target material.

The sputtering face of the target can be made even and smooth by miniaturizing and highly densifying the crystal grain of the ZnS-SiO₂ target, whereby yielding a characteristic of reducing particles and nodules as well as prolonging the target life. It is well known that the productivity of optical discs can be improved as a result thereof.

Nevertheless, with respect to the SiO₂ used in a conventional ZnS-SiO₂ target, employed were those having a high purity of 4N or more and having an average grain diameter of 0.1 to 20 µm, and are ordinarily manufactured by being sintered between 800 and 1200°C. With this temperature range, however, the SiO₂ itself will not deform or react with ZnS.

Thus, a ZnS-SiO₂ target manufactured as above easily creates a space between the ZnS and SiO₂, which becomes more noticeable when the SiO₂ is miniaturized, and, since the precision of the ZnS is also hindered thereby, there is a problem in that the target density will deteriorate.

When the target density deteriorates, there is another problem in that the mechanical strength will also deteriorate, and cracks will occur during the sputtering. In light of the above, a proposal has been made for increasing the strength by adding 10 to 1000ppm of aluminum oxide (alumina) and improving the sintering performance (Japanese Patent Laid-Open Publication No. H9-143703). Nevertheless, there is a problem in that the mere addition of alumina is not able to improve the density of the target.

Therefore, conventionally, it was necessary to make the manufacturing conditions for hot pressing or the like as high temperature and high pressure as possible in order to realize high densification. Nonetheless, for example, when manufacturing with hot pressing, more time is required for a single process pursuant to the increase in temperature, and the graphite mold retains its strength pursuant to the increase in pressure. It is thereby necessary to make the peripheral radial thickness thicker, and to reduce the load area portion. As a result, there is a problem in that the productivity per hot pressing batch will decrease significantly.

Contrarily, so as not to decrease productivity, although the hot pressing device may be enlarged in order to enlarge the graphite mold itself, this will lead to increased costs for such hot pressing device and graphite mold.

Due to the foregoing reasons, it was not conventionally possible to obtain a sputtering target for a ZnS-SiO₂ phase change optical disc protective film at a low cost.

Accordingly, in general, there was no choice but to use a low-density target. As a result, upon forming the film with sputtering, particles (raising dust) and nodules would arise during such sputtering, and there is a problem in that the evenness and quality of the deposition will decrease, thereby leading to the deterioration of productivity.

### Disclosure of the Invention

An object of the present invention is to enable the stable manufacture of a target at low cost and in which the crystal grain is minute and of a high density of 90% or more, and to thereby obtain a sputtering target for forming an optical disc protective film capable of further improving the evenness of deposition and increasing the productivity rate, and an optical recording medium having formed thereon a ZnS-SiO₂ phase change optical disc protective film upon employing the ZnS-SiO₂ sputtering target.

In order to achieve the foregoing object, as a result of intense study, the present inventors discovered that by employing a SiO₂ glass material in which an additive is added to the SiO₂, space between the ZnS can be reduced, high densification can be easily realized even upon miniaturizing the SiO₂, generation of particles and nodules arising at the time of sputtering can be reduced without detriment to the characteristics as a protective film, and evenness of the film thickness can also be improved.

Based on the foregoing discovery, the present invention provides:
1. A ZnS-SiO₂ sputtering target having a relative density of 90% or more characterized in being sintered with powder wherein 1 to 50mol% of SiO₂ glass powder containing, as an additive, a total of 0.01 to 20wt% of one or more types selected from a metal element, boron, phosphorus, arsenic or the oxides thereof, and the remnant ZnS powder are evenly dispersed and mixed;
2. A ZnS-SiO₂ sputtering target having a relative density of 90% or more characterized in being sintered with powder wherein 1 to 50mol% of SiO₂ glass powder containing, as an additive, a total of 0.01 to 20wt% of one or more types selected from a metal element, boron, phosphorus, arsenic or the oxides thereof, 0.01 to 30mol% of SiO₂ powder, and the remnant ZnS powder are evenly dispersed and mixed;
3. A ZnS-SiO₂ sputtering target according to paragraph 1 or paragraph 2 above, characterized in that the metal element is lithium, sodium, magnesium, aluminum, potassium, calcium, barium, or lead;
4. A ZnS-SiO₂ sputtering target according to each of paragraphs 1 to 3 above, characterized in that the average grain diameter of the SiO₂ crystal grain is 0.1 to 30µ m; and
5. An optical recording medium having formed thereon a ZnS-SiO₂ phase change optical disc protective film upon employing the ZnS-SiO₂ sputtering target according to each of paragraphs 1 to 4 above.

### Brief Description of the Drawings

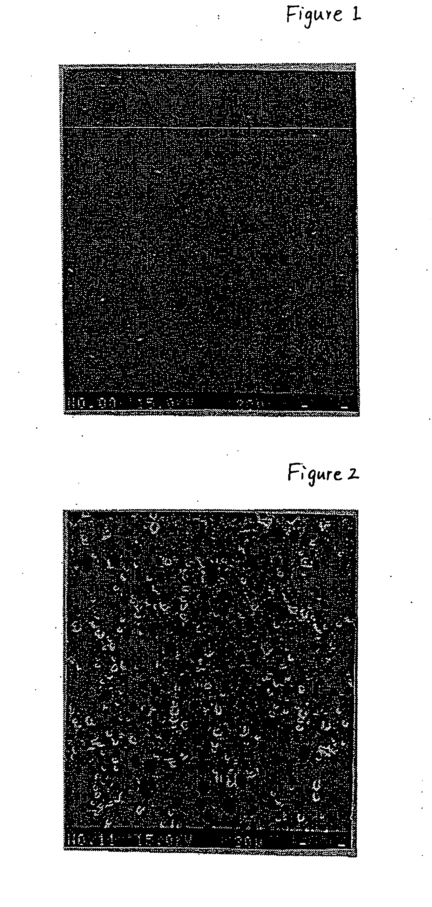

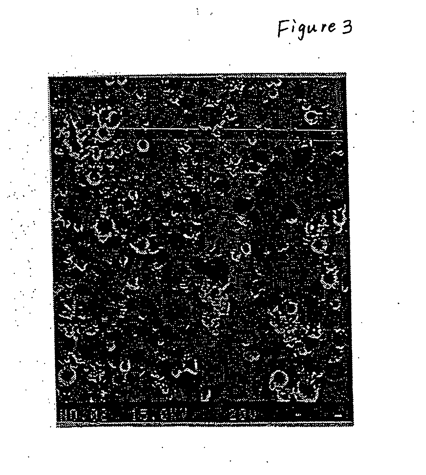

Fig. 1 is a microphotograph of the target surface obtained pursuant to Example 1; Fig. 2 is a microphotograph of the target surface obtained pursuant to Example 2; and Fig. 3 is a microphotograph of the target surface obtained in Comparative Example 1.

### Best Mode for Carrying Out the Invention

The present invention employs SiO₂ glass powder containing, as an additive, a total of 0.01 to 20wt% of one or more types selected from a metal element, boron, phosphorus, arsenic or the oxides thereof. As the foregoing metal element, in particular, it is desirable to use lithium, sodium, magnesium, aluminum, potassium, calcium, barium, or lead. As described above, a significant characteristic of the present invention is to use SiO₂ glass material.

Since the additive will be ineffective if the additive amount of the additive is less than 0.01wt%, and the film characteristics will change largely, which is not preferable, if the additive amount exceeds 20wt%, the total amount has been set between 0.01 and 20wt%.

The target is manufactured by evenly dispersing and mixing to 50mol% of the SiO₂ glass powder containing the foregoing additive elements and the remnant ZnS powder, and sintering this with hot pressing or the like.

It is further possible to add 0.01 to 30mol% of SiO₂ powder to the foregoing SiO₂ glass powder, evenly dispersing and mixing this with the remnant ZnS powder, and sintering this with hot pressing or the like. By adding the SiO₂ powder, the additive amount of the foregoing metal element may be reduced in accordance with the purpose of use, and high densification is possible even if the amount of SiO₂ composition is great. Moreover, it is desirable that each of the additive materials is of high purity, and, for example, although those having 99.99wt% or more are employed, the additive materials are not necessarily limited to this range.

Obtained thereby is a sputtering target for forming the ZnS-SiO₂ phase change optical disc protective film with not much space between the ZnS and SiO₂, and which has a relative density of 90% or more.

Moreover, by merely adding the foregoing materials, the ZnS-SiO₂ target crystal grain can be miniaturized and highly densified, and, therefore, yielded is a significant effect where the sputtering face of the target can be made even and smooth, particles and nodules at the time of sputtering can be reduced, and the target life can be prolonged. As a result, the productivity of the optical recording medium having formed thereon a ZnS-SiO₂ phase change optical disc protective film will increase, and a material superior in quality can be obtained thereby.

It is also possible to further improve the aforementioned characteristics by making the average grain diameter of the SiO₂ crystal grain 0.1 to 30 µm.

### Examples and Comparative Examples

The present invention is now described with reference to the Examples and Comparative Examples. These Examples are merely illustrative, and the present invention shall in no way be limited thereby. In other words, the present invention shall only be limited by the scope of claim for a patent, and shall include the various modifications other than the Examples of this invention.

### (Example 1)

SiO₂ glass powder having as its constitutional composition SiO₂-0.5 wt% Na₂O was evenly mixed with ZnS at a ratio of 20mol%.

This mixed powder was filled in a graphite die, and hot pressed under the conditions of an Ar atmosphere, a bearing of 150kg/cm², and a temperature of 1000°C.

The target obtained thereby had a relative density of 99%. The microphotograph of the surface of this target is shown in Fig. 1.

The black spherical shapes in Fig. 1 represent the SiO₂, and the average grain diameter of the SiO₂ crystal grain was 5 µ m or less, and space between the surfaces of ZnS and SiO₂ could hardly be acknowledged. As a result, obtained was a high-density sputtering target for forming a ZnS-SiO₂ phase change optical disc protective film.

### (Example 2)

SiO₂ glass powder having as its constitutional composition SiO₂-0.5wt% B₂O₃ was evenly mixed with ZnS at a ratio of 20mol%.

This mixed powder was filled in a graphite die, and hot pressed under the conditions of an Ar atmosphere, a bearing of 150kg/cm², and a temperature of 1000°C. The target obtained thereby had a relative density of 97%. As a result, obtained was a high-density sputtering target for forming a ZnS-SiO₂ phase change optical disc protective film. The SEM photograph thereof is shown in Fig. 2.

The black spherical shapes in Fig. 2 represent the SiO₂, and the average grain diameter of the SiO₂ crystal grain was 10 µm or less, and it is evident that the space between the surfaces of ZnS and SiO₂ is minimal.

### (Comparative Example 1)

SiO₂ powder having a purity of 99.99% or higher was evenly mixed with ZnS at a ratio of 20mol%.

This mixed powder was filled in a graphite die, and hot pressed under the conditions of an Ar atmosphere, a bearing of 150kg/cm², and a temperature of 1000°C. The target obtained thereby had a relative density of 94%. As a result, obtained was a sputtering target for forming a ZnS-SiO₂ phase change optical disc protective film inferior to the density yielded in the Examples of the present invention.

The microphotograph of the surface of this target is shown in Fig. 3. Similar to the above, the black spherical shapes in Fig. 3 represent the SiO₂, and many spaces between the surfaces of ZnS and SiO₂ could be acknowledged.

### Effects of the Invention

By employing the SiO₂ glass material of the present invention in which an additive was added to SiO₂, space between the ZnS can be reduced, and high densification can be easily realized even upon miniaturizing the SiO₂. Thus, a superior effect is yielded of being able to obtain a sputtering target for forming an optical disc protective film capable of suppressing the generation of particles (raising dust) and nodules arising at the time of sputtering without detriment to the characteristics as a protective film, improving the evenness of deposition and increasing the productivity rate, and an optical recording medium having formed thereon a ZnS-SiO₂ phase change optical disc protective film upon employing the ZnS-SiO₂ sputtering target.

## Claims

1. A ZnS-SiO₂ sputtering target having a relative density of 90% or more **characterized in** being sintered with powder wherein 1 to 50mol% of SiO₂ glass powder containing, as an additive, a total of 0.01 to 20wt% of one or more types selected from a metal element, boron, phosphorus, arsenic or the oxides thereof, and the remnant ZnS powder are evenly dispersed and mixed.

2. A ZnS-SiO₂ sputtering target having a relative density of 90% or more **characterized in** being sintered with powder wherein 1 to 50mol% of SiO₂ glass powder containing, as an additive, a total of 0.01 to 20wt% of one or more types selected from a metal element, boron, phosphorus, arsenic or the oxides thereof, 0.01 to 30mol% of SiO₂ powder, and the remnant ZnS powder are evenly dispersed and mixed.

3. A ZnS-SiO₂ sputtering target according to claim 1 or claim 2, **characterized in that** the metal element is lithium, sodium, magnesium, aluminum, potassium, calcium, or barium.

4. A ZnS-SiO₂ sputtering target according to each of claims 1 to 3, **characterized in that** the average grain diameter of the SiO₂ crystal grain is 0.1 to 30 µm.

5. An optical recording medium having formed thereon a ZnS-SiO₂ phase change optical disc protective film upon employing the ZnS-SiO₂ sputtering target according to each of claims 1 to 4.

## Amended claims

### Amended claims under Art. 19.1 PCT

**1.** (Amended) A ZnS-SiO₂ sputtering target having a relative density of 90% or more **characterized in** being sintered with powder wherein 1 to 50mol% of SiO₂ glass powder containing, as an additive, a total of 0.01 to 20wt% of one or more types selected from boron, phosphorus, arsenic, a metal element consist of lithium, sodium, magnesium, aluminum, potassium, calcium and barium or the oxides thereof, and the remnant ZnS powder are evenly dispersed and mixed.

**2.** Amended) A ZnS-SiO₂ sputtering target having a relative density of 90% or more **characterized in** being sintered with powder wherein 1 to 50mol% of SiO₂ glass powder containing, as an additive, a total of 0.01 to 20wt% of one or more types selected from boron, phosphorus, arsenic, a metal element consist of lithium, sodium, magnesium, aluminum, potassium, calcium and barium or the oxides thereof, 0.01 to 30mol% of SiO₂ powder, and the remnant ZnS powder are evenly dispersed and mixed.

**3.** (Delete)

**4.** (Amended) A ZnS-SiO₂ sputtering target according to claim 1 or claim 2, **characterized in that** the average grain diameter of the SiO₂ crystal grain is 0.1 to 30 µm.

**5.** (Amended) An optical recording medium having formed thereon a ZnS-SiO₂ phase change optical disc protective film upon employing the ZnS-SiO₂ sputtering target according to each of claim 1, claim 2 or claim 4.
